# EUROPEAN PATENT APPLICATION

(11) **EP 1 657 946 A2**
(43) Date of publication of application: **17.05.2006**
(21) Application number: 05024702.2
(22) Date of filing: 11.11.2005
(51) Int. Cl.: H04Q 7/38

(54) **Apparatus and method for tuning a broadcast channel**

(30) Priority: 11.11.2004 KR 2004091901
(71) Applicant: LG Electronics Inc., Yongdungpo-gu Seoul (KR)
(72) Inventor: Lee, Sung Ho, 126-509, Halla Maeul Jugong Apt., Bucheon-si, Gyeonggi-do (KR)
(74) Representative: Katérle, Axel

(57) **Abstract**

An apparatus for tuning a broadcast channel and method thereof are disclosed, by which a broadcast channel is tuned using a global positioning system (GPS) in a mobile multimedia broadcast receiving terminal, and by which a first broadcast channel is automatically changed to a second broadcast channel responsive to the terminal position. In tuning one of a plurality of broadcast channels belonging to a broadcasting station, the present invention includes an acquisition block acquiring position information, a calculation block calculating a position of a terminal using the position information, and a tuner for changing the broadcast channel responsive to the terminal position.

## Description

This application claims the benefit of the Korean Patent Application No. 10-2004-0091901, filed on November 11, 2004, which is hereby incorporated by reference as if fully set forth herein.

### FIELD OF THE INVENTION

[0001] The present invention relates to a multimedia broadcast, and more particularly, to an apparatus and method for tuning a broadcast channel. Although the present invention is suitable for a wide scope of applications, it is particularly suitable for tuning the broadcast channel in a mobile multimedia broadcast receiving terminal.

### BACKGROUND OF THE INVENTION

Currently, the consumer's demand for receiving a multimedia broadcast service is rapidly rising and a mobile reception of the multimedia broadcast is more demanded than ever.

Lately, various service functions as well as a general voice call function have been added to a mobile phone. A device for receiving a multimedia broadcast is further added to the mobile phone, which means that a portable mobile multimedia broadcast receiving terminal ("terminal") has been developed. The mobile terminal enables a multimedia broadcast service to be enjoyed using a conventional mobile phone display.

The mobile terminal consists of a voice frequency processing means for a voice communication and a broadcast frequency processing means for broadcast reception.

One example of the mobile terminal is a television phone.

Yet, in order for the mobile terminal to receive a prescribed multimedia broadcast, a process of tuning a corresponding broadcast channel is needed. In particular, since the mobile terminal has mobility, it is necessary to maintain the tuned broadcast channel continuously while the mobile terminal is moving.

For example, in the case of using the TV phone, since a user carrying the TV phone may keep moving around a prescribed area, the broadcast channel frequently changes in the TV phone. Moreover, since each area uses a different broadcast channel frequency, the broadcast channel change is inevitable due to the user's area movement.

If the user attempts to move away from the currently tuned broadcast channel area into another broadcast channel area while receiving the corresponding broadcast via the TV phone, the previous broadcast channel should be switched to another broadcast channel suitable for the current area into which the user has moved. For such a broadcast channel change, the user manually tunes the broadcast channel of the area into which the user has moved.

To overcome such an inconvenience, a device for automatically tuning a broadcast channel automatically has been developed.

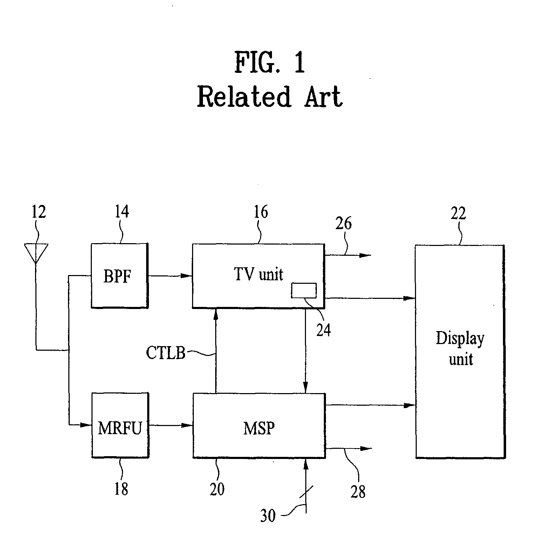

FIG. 1 is a block diagram showing a TV phone according to related art, in which the device automatically tunes a broadcast channel in the TV phone. Referring to FIG. 1, a TV phone according to a related art comprises of an antenna 12, a band pass filter (BPF) 14, a TV unit 16, a mobile radio frequency unit (MRFU) 18, a mobile station processor (MSP) 20 and a display unit 22.

The BPF 14 filters a broadcast signal of a TV band in a radio wave signal received via the antenna 12, and, the filtered output is provided to a TV unit 16.

The TV unit 16 selects a broadcast channel requested by a user and then demodulates the selected broadcast signal (e.g., video signal and voice signal). In doing so, the TV unit 16 selects the broadcast signal of the user-requested broadcast channel to correspond to a control signal externally provided for a broadcast channel tuning.

The TV unit 16 is provided with a level/noise detector 24. The level/noise detector 24 measures a level of a video signal or a noise level of the video signal in the broadcast channel.

The MRFU 18 receives an incoming call to establish a voice communication channel and demodulates a signal corresponding to the incoming call. The MRFU 18 also modulates a signal of an outgoing call.

The MSP 20 sets either a phone mode or a TV mode (reception mode for mobile multimedia broadcast) in response to a command provided by BUS 30. In case that the TV mode is set, the MSP 20 provides the control signal for the broadcast channel tuning to the TV unit 16.

If the level or noise level of the video signal measured by the level/noise detector 24 is lower than a preset reference level, the MSP 20 selects a broadcast channel of another area to replace the currently selected broadcast channel and then provides a channel selection signal for tuning the selected broadcast channel to the TV unit 16.

Moreover, if a signal corresponding to an incoming call is provided from the MRFU 18, the MSP 20 disables the TV unit 16. The MSP 20 then accesses the MRFU 18 to process the incoming call.

The display unit 22 displays the video signal provided by the TV unit 16, and displays a character message provided by the MSP 20.

According to FIG. 1, if a user is viewing a broadcast program from a specific broadcasting station and moves away from the broadcast area into another area, the user is able to continue viewing the currently viewed broadcast program seamlessly in the other area into which he has moved.

A microprocessor, a video CODEC and the like are located in the MSP 20.

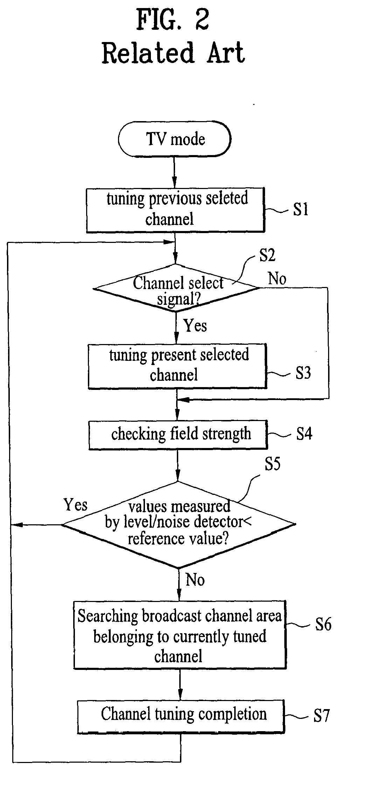

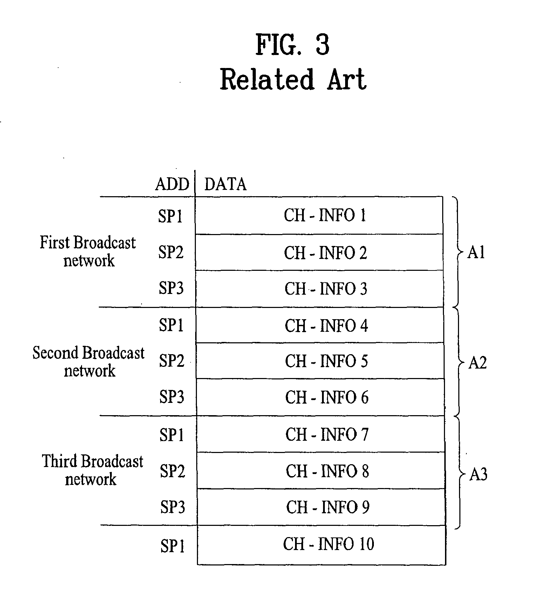

FIG. 2 shows a flowchart of a control process for switching a broadcast channel of a TV phone automatically according to the related art, and FIG. 3 shows an exemplary memory table containing TV broadcast channel information according to the related art.

As shown in FIG. 2, program masking is performed on a read only memory (ROM) provided within the MSP 20 of FIG. 1, and a memory table in FIG. 3 is stored in a memory area within the MSP 20. For instance, the memory area is a volatile area like a random access memory (RAM) or a non-volatile area like an electrical erasable programmable read only memory (EEPROM) or the like.

A memory table retaining TV broadcast channel information is explained with reference to FIG. 3 as follows. First, broadcast channels of various broadcasting stations are classified into A1, A2 and A3 in the memory table of FIG. 3, respectively. For instance, a first broadcasting network has a broadcast channel A1, a second broadcasting network has a broadcast channel A2, and an third broadcasting network has a broadcast channel A3. Each of the broadcast channels A1, A2 and A3 has a plurality of local broadcast channels SPi, where 'i' is a natural number such as 1, 2, 3, etc..

Tuning information associated with each of the broadcast channels of the respective areas is stored in a storage area identified by the local broadcast channels SPi of the broadcasting station.

For instance, the broadcast channel tuning information for viewing a program of the first broadcasting network is stored in the storage area allocated to the local broadcast channel SP1 of the broadcast channel A1 corresponding to the first broadcasting network that covers a first metropolitan area area. The broadcast channel tuning information for viewing a program of the first broadcasting network is stored in the storage area allocated to the local broadcast channel SP2 of the broadcast channel A1 corresponding to the first broadcasting network that covers a second metropolitan area. And, the broadcast channel tuning information for viewing a program of the first broadcasting netowrk is stored in the storage area allocated to the local broadcast channel SP3 of the broadcast channel A1 corresponding to the KBC broadcasting station that covers a third metropolitan area.

If the TV phone moves from the current local broadcast channel coverage area, the tuning information corresponding to the local broadcast channel within the broadcast channel A1 is sequentially accessed to perform the automatic tuning. Therefore, a user is able to continue viewing the program of the current broadcast channel regardless of leaving the corresponding area or not.

The control flow for the automatic broadcast channel switching of the TV phone according to the related art is explained in detail with reference to FIG. 1 and FIG. 2 as follows. The TV phone shown in FIG. 1 is set to TV mode so that the TV unit 16 receives a signal (e.g., a broadcast signal of the first broadcasting network which covers the first metropolitan area) of a specific broadcast channel and then demodulates the received signal. The voice and video signals are provided to an external line 26 and the display unit 22.

If the TV unit 16 is turned on/off according to the control signal CTLB provided from the MSP 20 or performs an operation such as the broadcast channel tuning and the like, the level/noise detector 24 measures the noise level of the video signal in the tuned broadcast channel or a reception field strength from the tuned broadcast channel. If the video signal is provided to the display unit 22 of the TV phone, the MSP 20 controls a tuning operation of the broadcast channel according to the flowchart shown in FIG. 2.

If a user sets the TV mode by operating a prescribed key of the TV phone, the MSP 20 provides a control signal, CTLB, for tuning the broadcast channel. Subsequently, the MSP 20 checks whether a signal is provided to the BUS line 30. In this case, the signal provided to the BUS line 30 is the channel selection signal. Hence, the MSP 20 searches whether the channel selection signal is provided via the BUS line 30 (S2).

The MSP 20 provides a tuning control signal, CTLB, to the TV unit 16 (S3). The TV unit 16 performs a tuning operation in response to the tuning control signal CTLB2. Hence, by selecting the frequency of one broadcast channel tuned from a plurality of the broadcast channels, a reception signal of the corresponding tuned broadcast channel is demodulated.

While demodulating the reception signal of the currently tuned broadcast channel, the MSP 20 checks the reception field strength measured from the currently tuned broadcast channel by the level/noise detector 24 (S4).

When the signal provided from the BUS line 30 is not the channel selection signal, the MSP 20 checks the reception field strength measured from the currently tuned broadcast channel by the level/noise detector 24 and the level and noise level of the video signal as well.

Subsequently, the MSP 20 compares the values (video signal level, noise level of the video signal, reception field strength) measured by the level/noise detector 24 to reference values previously set in the internal memory area (S5).

For example, if the measurement result provided to the MSP from the level/noise detector 24 is the video signal level or the reception field strength, a reference video signal level or reference field strength is used as the reference value previously set in the internal memory area. Hence, the MSP 20 compares the corresponding reference value to the current measurement result value. If the current measurement result value is lower than the reference value (video signal level or reference field strength), the MSP 20 performs automatic tuning operation (S6, S7) of the broadcast channel with reference to the memory table shown in FIG. 3.

On the other hand, if the measurement result from the level/noise detector 24 is the noise level of the video signal, the MSP 20 uses a reference noise level as a reference value previously set in the internal memory area, and the MSP 20 compares the reference noise level value to the measurement result value of the level/noise detector 24. If the measurement result value of the level/noise detector 24 is higher than the reference noise level, the MSP 20 performs automatic tuning operation (S6, S7) of the broadcast channel with reference to the memory table shown in FIG. 3.

The automatic tuning operation is a procedure wherein the MSP 20 sequentially searches channel tuning information of the local broadcast channels of the currently tuned broadcast channel.

The automatic tuning operation is explained in detail as follows. First, the MSP 20 searches the local broadcast channels belonging to the currently tuned broadcast channel in the memory table shown in FIG. 3 (S6). For instance, if the tuning information corresponding to the currently tuned broadcast channel is 'CH-INFO1', the local broadcast channels belonging to the broadcast channel A1 are searched. Such a searching operation is executed by scanning the contents stored in the memory table.

Specifically, the searching operation starts from the tuning information 'CH-INFO2' next to the currently tuned 'CH-INFO1'. To provide the searched tuning information, the MSP 20 increments an address pointer. The MSP 20 then provides a tuning control signal for selecting the corresponding tuning information to the TV unit 16. Thus, the broadcast channel tuning procedure is completed (S7).

After completion of the broadcast channel tuning, the TV unit 16 selects a broadcast signal of the corresponding broadcast channel only from the signals received from the BPF 14 in response to the tuning control signal that is provided by the MSP 20 and then demodulates the video and voice signals of the selected broadcast channel.

In doing so, as mentioned in the foregoing description, the level/noise detector 24 measures the level or noise level of the video signal demodulated in the TV unit 16 or the reception field strength, and, the MSP 20 repeats the entire procedure.

In the above explained related art, the level or noise level of the video signal or the reception field strength is measured while a user watches TV. A broadcast channel is automatically tuned using the result from comparing the measured value to the preset reference value.

In the related art, the reception field strength and the like are measured at each reception of the broadcast signal or periodically. Yet, the reception field strength varies due to various factors including the movement of the TV phone. Hence, the reception field strength in the related art is frequently lowered due to various factors even if the TV phone does not move away into a different broadcast channel area.

The broadcast channel can be automatically changed if the reception field strength is lowered not by the geographical movement of the TV phone but by the different factors not necessitating broadcast channel change. This is because the related art changes the broadcast channel with the field strength information only not based on the mobile terminal position.

In brief, the broadcast channel may be changed in the related art even if the change of the broadcast channel is unnecessary. Since the current position information of the mobile terminal is not provided, a search for the frequencies of the entire peripheral broadcast channels at the timing point of changing the broadcast channel is needed. Hence, significant time is required to complete the accurate broadcast channel tuning.

### SUMMARY OF THE INVENTION

Accordingly, the present invention is directed to an apparatus and method for tuning a broadcast channel that substantially solves one or more problems due to limitations and disadvantages of the related art.

An object of the present invention is to provide an apparatus and method for tuning a broadcast channel, by which a broadcast channel is tuned using global positioning system (GPS) data in a mobile terminal supporting a mobile multimedia broadcast receiving service.

Another object of the present invention is to provide an apparatus and method for tuning a broadcast channel thereof, by which a currently received broadcast in a current area is re-tuned based on accurate position information when a mobile terminal is moved into another area while receiving the broadcast.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, in tuning one of a plurality of local broadcast channels belonging to a broadcasting station, an apparatus for tuning the broadcast channel according to the present invention comprises: an acquisition block acquiring position information; a calculation block calculating a position of a terminal using the position information; and a tuner checking the position of the terminal in order to change the broadcast channel responsive to the geographical position of the receiver.

Preferably, the apparatus is located in the terminal, and the terminal is a mobile phone.

Preferably, the apparatus further includes a memory table containing frequencies of the local broadcast channels belonging to the broadcasting station and position information indicating geographical areas of the local broadcast channels.

More preferably, the memory table further contains identifiers of the local broadcast channels. More preferably, the memory table further contains identifiers identifying broadcast channels of a plurality of broadcasting.

More preferably, the tuner checks that the position of the terminal is in the geographical area of one of the local broadcast channels by comparing the position of the terminal to the position information of the local broadcast channels contained in the memory table. More preferably, the tuner searches the memory table for the geographical area of the local broadcast channel to which the terminal is tuned.

Preferably, the apparatus further includes a processing block receiving a broadcast signal of the changed broadcast channel frequency, demodulating the received broadcast signal and providing the demodulated signal to a display.

In another aspect of the present invention, an apparatus for tuning a broadcast channel comprise a memory storing broadcast channel frequencies and coordinate information indicating geographical areas of the broadcast channels, a calculation block for calculating a position of a terminal, a tuner for searching the memory for the broadcast channel frequency corresponding to the position of the terminal, and a processing block demodulating the corresponding broadcast signal received via the searched frequency of the broadcast channel.

Preferably, the terminal includes a GPS receiver for receiving position information of the terminal from a GPS satellite and providing the position information to the calculation block.

Preferably, the tuner checks that the terminal position is within the geographical area of one of the broadcast channels by comparing the position of the terminal to the coordinate information of the broadcast channels stored in the memory. The tuner searches the broadcast channel frequencies for present geographical location of the terminal.

In another aspect of the present invention, in tuning one of a plurality of local broadcast channels belonging to a prescribed broadcasting station in a terminal, a method of tuning the broadcast channel comprises the steps of acquiring position information of the terminal, calculating a position of the terminal using the position information, checking the position of the terminal with the local broadcast channel area, changing a current broadcast channel frequency of the terminal to a broadcast channel frequency corresponding to the checked area, and receiving a broadcast signal of the changed broadcast channel frequency.

Preferably, the method further includes the step of previously storing frequencies of the local broadcast channels belonging to the prescribed broadcasting station, and geographical areas of the local broadcast channels.

More preferably, the terminal position is compared to the previously stored position local broadcast channel information and to the geographical area of the local broadcast channel to which the terminal is tuned.

Preferably, the terminal acquires the position information from a GPS satellite.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a block diagram of an internal configuration of a TV phone according to a related art;

FIG. 2 is a flowchart of a control process for switching a broadcast channel of a TV phone automatically according to a related art;

FIG. 3 is an exemplary memory table containing TV broadcast channel information according to a related art;

FIG. 4 is a schematic diagram of an overall configuration of a mobile multimedia broadcast system according to the present invention;

FIG. 5 is a block diagram of a mobile terminal according to the present invention;

FIG. 6 is a flowchart of a control process for automatic reception of a broadcast channel in a mobile terminal according to the present invention; and

FIG. 7 is an exemplary diagram of a memory table containing local broadcast channels (frequencies) of broadcasting stations and position information of the local broadcast channels of each of the broadcasting stations according to the present invention.

### DETAILED DESCRIPTION OF THE EMBODIMENTS

Reference will now be made in detail to the preferred embodiments of the present invention, examples of which are illustrated in the accompanying drawings. Wherever possible, the same reference numbers will be used throughout the drawings to refer to the same or like parts.

In the present invention, a GPS receiver supporting a satellite position check service is provided within a mobile terminal to receive the information of a current position of the mobile terminal.

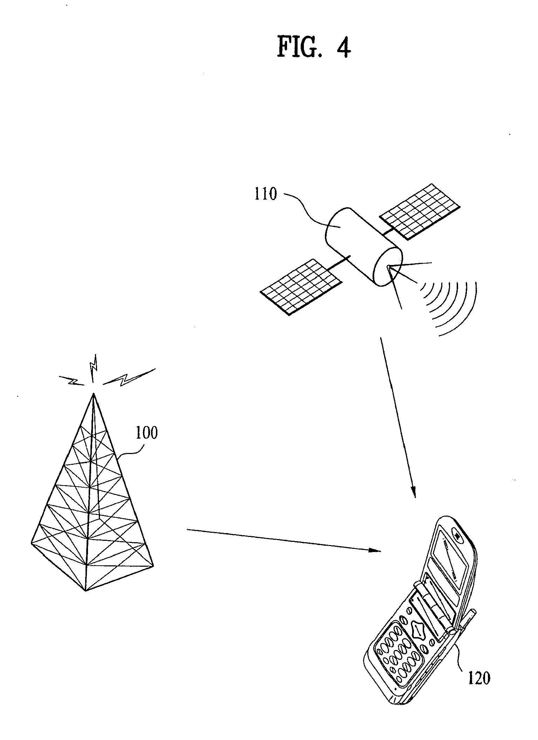

FIG. 4 is a schematic diagram of an overall configuration of a mobile multimedia broadcast system according to the present invention, wherein a mobile multimedia broadcast system according to the present invention includes a mobile terminal 120, a transmitting antenna 100 transmitting a broadcast signal of a prescribed broadcast channel to the terminal 120, and a GPS satellite 110 providing position information to the terminal 120.

The terminal 120 is a mobile phone, personal communication system (PCS) terminal, personal digital assistant (PDA) or the like to be provided with a mobile communication service including voice and data services by wireless.

The terminal 120 receives a GPS satellite signal for measuring its position from the GPS satellite 110. The terminal also receives a broadcast signal transmitted from a prescribed broadcasting station via a transmitting antenna 100. Hence, the terminal 120 obtains a position using the GPS satellite signal received from the GPS satellite 110 and then carries out an automatic tuning based on the obtained position.

In the present invention, the terminal 120 receives both the broadcast signal from the transmitting antenna 100 and the position information from the GPS satellite 110.

An internal configuration and operation of a terminal for automatically tuning a broadcast channel according to one embodiment of the present invention is explained as follows.

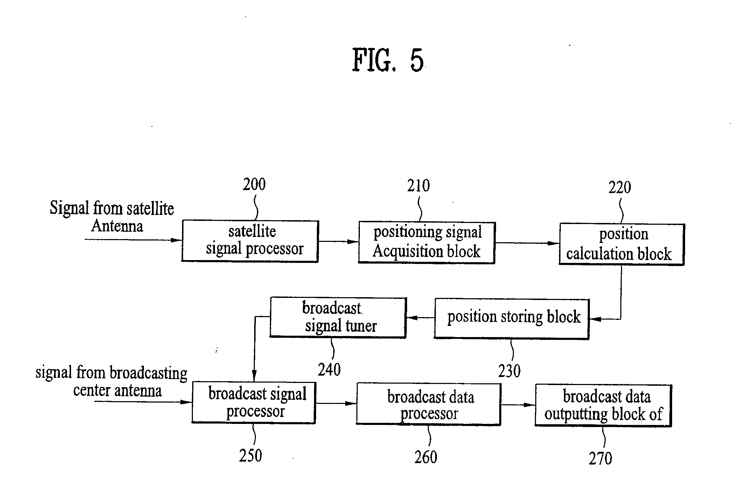

FIG. 5 is a block diagram of a mobile terminal according to the present invention, wherein a terminal of the present invention includes a GPS receiver and various units for tuning to a broadcast channel based on position information provided from the GPS receiver.

In particular, the terminal of the present invention includes a satellite signal processor 200 for processing a satellite signal received from a GPS satellite antenna, a positioning signal acquisition block 210 for acquiring position information from an output of the satellite signal processor 200, a position calculation block 220 for calculating a coordinate value corresponding to a position of the terminal using the position information acquired by the satellite signal acquisition block 210, a position storing block 230 for storing coordinate values calculated by the position calculation block 220, a broadcast signal tuner 240 for tuning a broadcast channel for a broadcast signal transmitted from a transmitting antenna of a broadcasting station, a broadcast signal processor 250 for receiving the broadcast signal from the transmitting antenna of the broadcasting station and then processing the received broadcast signal, a broadcast data processor 260 for processing broadcast data using an output of the broadcast signal processor 250, and a broadcast data output block 270 providing an output of the broadcast data processor 260 to a display unit.

An operation of the above-configured terminal is explained as follows.

The satellite signal processor 200 and the satellite signal acquisition block 210 receive the satellite signal from the GPS satellite. Position information is acquired from a result of processing the received satellite signal.

The position calculation block 220 calculates coordinates for the current position of the terminal using the acquired position information.

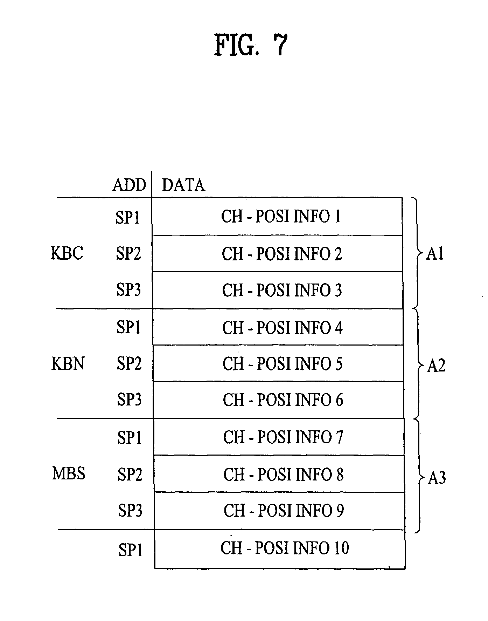

The terminal according to the present invention includes a memory table, as shown in FIG. 7, containing local broadcast channels of broadcasting stations and the geographical area of each of the broadcasting stations.

The memory table in FIG. 7 has identifiers A1, A2 and A3 to identify the broadcast channels of the broadcasting stations, respectively. For instance, a first broadcasting network has a broadcast channel set to A1, a second broadcasting network has a broadcast channel set to A2, and an third broadcasting network has a broadcast channel set to A3.

The memory table has identifiers of a plurality of local broadcast channels SPi (where, 'i' is 1, 2, 3, etc.) corresponding to a plurality of the local broadcast channels to identify the respective broadcast channels on the basis of area.

A frequency of each of the local broadcast channels and geographic information corresponding to the broadcast area of each of the local broadcast channels are stored in a storage area.

For instance, a broadcast channel frequency covering a first metropolitan area and coordinate information corresponding to the geographic area of the first metropolitan area are stored in a storage area allocated to one local broadcast channel SP1 in the broadcast channel A1 for the first broadcasting network. A broadcast channel frequency covering a second metropolitan area and coordinate information corresponding to the geographic area of the second metropolitan are stored in a storage area allocated to one local broadcast channel SP2 in the broadcast channel A1 for the first broadcasting network. A broadcast channel frequency covering a third metropolitan area and coordinate information corresponding to the geographic area of the third metropolitan area are stored in a storage area allocated to one local broadcast channel SP3 in the broadcast channel A1 for the first broadcasting network.

The position calculation block 220 compares the coordinate values of the current position information to the coordinate information of the memory table shown in FIG. 7. The comparison operation verifies that the coordinate values belong to the geographical area of the local broadcast channel.

The position storing block 230 stores the coordinate values calculated by the position calculation block 220 and the local broadcast channel areas is confirmed based on the position information as the comparison result of the position calculation block 220.

Preferably, the memory table shown in FIG. 7 is provided to the position storing block 230. Namely, the position storing block 230 stores at least one coordinate value indicating the geographical area of the corresponding local broadcast channels. Optionally, the position storing block 230 further storse areas of the local broadcast channel in which the terminal is frequently located.

The broadcast signal tuner 240 caries out automatic tuning of a broadcast channel according to the terminal position stored in the position storing block 230. Namely, if the terminal moves to a new location, the broadcast signal tuner 240 selects a frequency of the local broadcast channel responsive to the position of the terminal stored in the position storing block 230.

After completion of the channel tuning, the broadcast signal processor 250 receives and processes the broadcast signal from the local broadcasting station corresponding to the local broadcast channel of the corresponding broadcasting station. The broadcast signal processor 250 then extracts broadcast data from the broadcast signal.

The received broadcast signal is demodulated by the broadcast signal processor 250 and the broadcast data processor 260. The demodulated signal is then provided to the display unit of the terminal.

An automatic channel tuning procedure in a mobile terminal according to a one embodiment of the present invention is explained as follows.

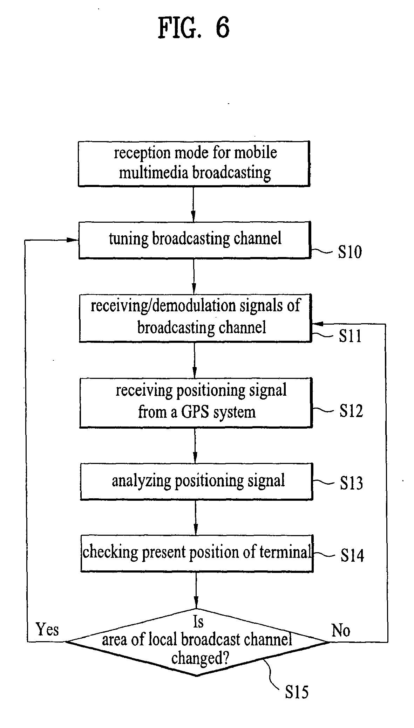

FIG. 6 is a flowchart of a control process for automatic reception of a broadcast channel in a mobile terminal according to the present invention. Referring to FIG. 6, in order for a terminal of the present invention to operate in TV mode, an MSP provides a control signal for tuning a broadcast channel to a TV unit. Hence, a broadcast signal tuner of the TV unit performs a broadcast channel tuning operation in response to the control signal of the MSP (S10).

A broadcast signal processor receives the broadcast signal tuned by the broadcast signal tuner and then demodulates the received broadcast signal (S11). In particular, the broadcast signal tuner tunes one broadcast channel in response to the control signal provided by the MSP. The broadcast signal processor and the following elements (broadcast data processor, broadcast data outputting block and the like) extract the broadcast signal of the broadcast channel and demodulate the extracted signal thereby providing video and voice signals.

A GPS receiver of the terminal receives position information from a GPS satellite and provides the received position information to the blocks (FIG. 5) performing the tuning of the broadcast channel. Specifically, the position calculation block shown in FIG. 5 receives a positioning signal from the GPS receiver (S12) and then analyzes the received positioning signal (S13).

Meanwhile, through the analysis of the positioning signal, the current position of the terminal is checked to determine whether the terminal has moved from one local broadcast channel area to another local broadcast channel area (S14).

In particular, the position calculation block of the terminal obtains the current position of the terminal using the position information received from the GPS receiver and then compares the obtained position of the terminal with the geographical area of each local broadcast channel thereby confirming whether the terminal has moved from one local broadcast area to another local broadcast area (S15).

If the location of the terminal has changed, the broadcast signal tuner tunes a local broadcast channel corresponding to the new position of the terminal (S10). If not, through the same procedures explained in the above description, a broadcast signal of the tuned broadcast channel is received, demodulated and outputted (S11).

The terminal of the present invention may be operated either in the mode for performing the automatic tuning of the broadcast channel based on the position information provided from the GPS satellite or in a field strength mode for performing the related art tuning of the broadcast channel in FIG. 2.

The terminal of the present invention includes a mobile terminal enabling a wireless communication service such as a mobile phone, personal digital assistant (PDA), notebook computer and the like.

And, the means for providing the position information is not limited to the satellite but uses various schemes that can provide the position of the mobile terminal. For instance, a mobile communication network itself can detect the position of the terminal. Hence, the GPS receiver may not be provided to the mobile terminal according to the position providing schemes.

Accordingly, the present invention provides the following effects or advantages.

First, in the present invention, even if a user who is viewing a program of a specific broadcasting station using the mobile terminal, moves away into another area, the broadcast channel is automatically changed into the local broadcast channel of the corresponding local broadcast station based on the position information of the terminal.

Hence, the present invention facilitates the user's convenient enjoyment of the mobile multimedia broadcast service.

Second, if the mobile terminal moves away into another area while receiving the corresponding broadcast, a broadcast channel of a new position is automatically tuned based on the accurate position information.

Hence, the present invention enables the terminal to continue receiving the corresponding broadcast by automatically tuning the local broadcast channel.
It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. An apparatus for a mobile multimedia broadcast receiving terminal for tuning a broadcast channel, wherein the broadcast channel is one of a plurality of broadcast channels of a broadcast station, and wherein the terminal has a current position, the apparatus comprising:
an acquisition block for acquiring position information;
a calculation block for computing the current position of the terminal using the position information; and
a tuner for checking that the current position of the terminal is within a broadcast area of one of the plurality of broadcast channels, and for tuning the one of the plurality of broadcast channels responsive to the current position of the terminal.

2. The apparatus of claim 1, wherein the apparatus is loaded in the terminal.

3. The apparatus of claim 1, further comprising a memory table containing frequencies and broadcast areas of the plurality of broadcast channels.

4. The apparatus of claim 3, wherein the memory table further contains identifiers of the broadcast channels.

5. The apparatus of claim 3, wherein the memory table further contains identifiers for broadcast channels of a plurality of broadcasting stations.

6. The apparatus of claim 3, wherein the tuner checks that the position of the terminal is in the geographical area of one of the plurality of broadcast channels by comparing the current position of the terminal to the broadcast areas of the broadcast channels contained in the memory table.

7. The apparatus of claim 6, wherein the tuner searches the memory table for the broadcast channel geographical area of the current location of the terminal.

8. The apparatus of claim 1, further comprising a processing block receiving a broadcast channel responsive to the current position of the terminal, wherein the processing block demodulates the received broadcast signal.

9. An apparatus for tuning a broadcast channel, comprising:
a memory for storing frequencies and broadcast areas of broadcast channels of a broadcasting station;
a calculation block for computing a position of the apparatus;
a tuner for searching the memory for the frequency of the broadcast channel corresponding to the position of the apparatus; and
a processing block for demodulating a signal corresponding to one of the broadcast channels responsive to the location of the apparatus.

10. The apparatus of claim 9, wherein the apparatus further comprises a global positioning system receiver (GPS) for receiving position information from a GPS satellite, the GPS receiver providing the received position information to the calculation block.

11. The apparatus of claim 9, wherein the apparatus is located within a mobile terminal.

12. The apparatus of claim 9, wherein the tuner checks that the position of the terminal is in the geographical area of one of the plurality of broadcast channels by comparing the current position of the terminal to the broadcast areas of the broadcast channels contained in the memory.

13. A method of tuning a broadcast channel in a terminal, wherein the broadcast channel is one of a plurality of broadcast channels belonging to a broadcasting station, and wherein each broadcast channel has a broadcast area, the method comprising the steps of:
acquiring position information relating to a current position of the terminal;
calculating the current position of the terminal using the position information;
identifying the broadcast channel by comparing the current position of the terminal with the broadcast areas of the plurality of broadcast channels;
changing a current broadcast channel to the broadcast channel identified using the position of the terminal; and
receiving the changed broadcast channel.

14. The method of claim 13, further comprising the step of previously storing frequencies and broadcast areas of the plurality of broadcast channels.

15. The method of claim 14, wherein the position of the terminal is compared to the previously stored broadcast areas for each of the plurality of broadcast channels.

16. The apparatus of claim 13, wherein the terminal acquires the position information from a global positioning system satellite.
